# EUROPEAN PATENT APPLICATION

(11) **EP 4 807 790 A1**
(43) Date of publication of application: **16.09.2026**
(21) Application number: 24887234.3
(22) Date of filing: 21.02.2024
(51) Int. Cl.: H01L 23/373, H01L 23/367, H01L 23/14, H01L 23/492

(54) **VIRTUAL CURRENCY COMPUTING CHIP PACKAGE AND CIRCUIT DEVICE**

(30) Priority: 09.11.2023 CN 202311495162
(71) Applicant: Bitdeer Semiconductor Technology PTE. LTD., 049514 Singapore (SG)
(72) Inventor: DAI, Qiang, Shenzhen, Guangdong 518000 (CN)
(74) Representative: Metida
(86) International application number: PCT/CN2024/077948
(87) International publication number: WO 2025/097607

(57) **Abstract**

Disclosed are a chip package and a circuit device for virtual currency computation. The die power terminals and the die signal terminals of a die in the chip package are respectively soldered to the substrate power terminals and the substrate signal terminals of a package substrate. The substrate signal terminals are electrically connected to the chip signal terminals via conductive traces inside the package substrate; and each of the first metal piece and the second metal piece are electrically connected to the substrate positive power terminal and the substrate negative power terminal respectively via a respective conductive trace inside the package substrate; a thickness of the metal plating layer is less than that of the first metal piece and a thickness of the second metal piece, and an area of the metal plating layer is less than that of the first metal piece and an area of the second metal piece. A projection of the metal plating layer on a surface where the first metal piece is disposed is located within the first metal piece, and the die is electrically isolated from both the first metal piece and the second metal piece; the metal plating layer, the first metal piece, the second metal piece, and the chip signal terminals are configured to be soldered to a surface on one side of a metal-based circuit board. According to the present disclosure, the heat dissipation efficiency of the chip package is improved while the probability of damaging the die is reduced.

## Description

### TECHNICAL FIELD

The present disclosure relates to chip packaging, and in particular, to a chip package and a circuit device for virtual currency computation.

### BACKGROUND

The producing of virtual currency (commonly known as "mining") relies on complex and massive computations which are performed by a large number of dedicated computing chips. During the computation process, the computing chips generate a large amount of heat. If the heat from the computing chips is not dissipated in time, the performance of the computing chips is prone to be degraded.

In some existing chip packages, power pins and signal pins for soldering to a circuit board are disposed on one surface of the chip package, and a die on the other surface of the chip package is attached to a heat sink via an interface material in a gel or paste form (e.g., a conductive adhesive) for heat dissipation. In some other chip packages, power pins and signal pins for soldering to a circuit board are disposed on one surface, and on, a surface of a die on the same surface of the chip package is attached to a thermal separation boss on a metal-based circuit board via an interface material in a gel or paste form (e.g., a conductive adhesive) for heat dissipation.

However, the heat dissipation efficiency of the above-described chip packages is still relatively low, which cannot meet the heat dissipation requirements for chip packages for virtual currency computation.

### SUMMARY

In view of the above, a main object of the present disclosure is to provide a chip package and a circuit device for virtual currency computation, which is capable of improving the heat dissipation efficiency of the chip package while reducing the probability of damaging the die.

To achieve the above objective, the present disclosure employs the following technical solutions:

A chip package for virtual currency computation is provided. The chip package includes a package substrate and a die, the package substrate includes substrate power terminals and substrate signal terminals arranged on a surface thereof; the substrate power terminal includes a substrate positive power terminal and a substrate negative power terminal, the die includes die power terminals and die signal terminals arranged on an upper surface thereof, the die power terminals and the die signal terminals are soldered to the substrate power terminals and the substrate signal terminals respectively; a protruding portion surrounding a periphery of the die and protruding in relative to the die is arranged on the package substrate, and the protruding portion comprises a plurality of chip signal terminals, a first metal piece, and a second metal piece arranged on a surface thereof; the substrate signal terminals are electrically connected to the chip signal terminal via a conductive trace inside the package substrate; each of the first metal piece and the second metal piece are electrically connected to the substrate positive power terminal and the substrate negative power terminal respectively via a respective conductive trace inside the package substrate; a metal plating layer is disposed on a lower surface of the die, wherein a thickness of the metal plating layer is less than a thickness of the first metal piece and a thickness of the second metal piece, and an area of the metal plating layer is less than an area of the first metal piece and an area of the second metal piece; a projection of the metal plating layer on a surface where the first metal piece is disposed is located within the first metal piece, and the die is electrically isolated from both the first metal piece and the second metal piece; and the metal plating layer, the first metal piece, the second metal piece, and the chip signal terminal are configured to be soldered to a surface on one side of a metal-based circuit board.

In some embodiments, the first metal piece has a metal projection part, and the second metal piece has a metal recess part, the metal projection part extends into the metal recess part; and the projection of the metal plating layer on the surface where the first metal piece is disposed completely is located within the metal projection and is thus surrounded by the metal projection part.

In some embodiments, the first metal piece and the second metal piece are arranged in a side-by-side manner, and each of the first metal piece and the second metal piece has a rectangular outer contour; and the projection of the metal plating layer on the surface where the first metal piece is disposed completely is located within the first metal piece and is thus surrounded by the first metal piece.

In some embodiments, the first metal piece has a notch part, the second metal piece is in a rectangular shape, and the first metal piece and the second metal piece are arranged in a side-by-side manner; and the projection of the metal plating layer on the surface where the first metal piece is disposed is located within the notch part of the first metal piece.

In some embodiments, three sides of the projection of the metal plating layer on the surface where the first metal piece is disposed respectively face three sides of the notch part, and a fourth side of the projection faces a fourth side of the second metal piece.

In some embodiments, the chip signal terminals are arranged on a first side region and an opposite second side region of the package substrate, and the first metal piece and the second metal piece are disposed between the chip signal terminals on the first side region and the chip signal terminals on the second side region.

In some embodiments, multiple layers of conducive traces are disposed inside the package substrate.

In some embodiments, the package substrate includes a base substrate, and the protruding portion is formed by plastic molding; wherein a plurality of copper pillars are disposed inside the protruding portion, and the copper pillars are configured as a circuit part of the chip signal terminal, the first metal piece, and the second metal piece inside the package substrate.

In some embodiments, the metal plating layer is a nickel-palladium-gold, copper, or nickel plating layer.

A circuit device for virtual currency computation is further provided. The circuit device includes a metal-based circuit board and the chip package for virtual currency computation as described above; the metal-based circuit board includes a metal substrate, a thermal separation boss is disposed on the metal substrate, and an insulating layer is disposed on a surface of the metal substrate other than the thermal separation boss, a conductive layer being disposed on the insulating layer, the conductive layer including a first power pad, a second power pad, and a plurality of signal pads; and the metal plating layer is soldered to the thermal separation boss; herein the first metal piece, the second metal piece, and the chip signal terminals are respectively soldered to the first power pad, the second power pad, and the signal pads.

A circuit device for virtual currency computation is provided. The circuit device includes a metal-based circuit board and the chip package as described above; the metal-based circuit board includes a metal substrate, an insulating layer is disposed on a surface of the metal substrate, a conductive layer being disposed on the insulating layer, the conductive layer including a heat dissipation pad, a first power pad, a second power pad, and a plurality of signal pads; the metal plating layer, the first metal piece, the second metal piece, and the chip signal terminals are respectively soldered to the heat dissipation pad, the first power pad, the second power pad, and the signal pads.

In some embodiments, a glass transition temperature of the metal-based circuit board is greater than or equal to 170°C such that a probability of the metal-based circuit board crushing and damaging the die due to bending is reduced.

In the above solution, after the chip package for virtual currency computation is soldered to the metal-based circuit board, the die is soldered to a corresponding heat dissipation pad or a thermal separation boss on the metal-based circuit board via the very thin metal plating layer, and a large amount of heat generated by the die due to virtual currency computation may be easily transferred to the metal-based circuit board and subsequently dissipated by the metal base, such that the heat dissipation efficiency is improved. In addition, the projection of the metal plating layer on the surface where the first metal piece is disposed is located within the first metal piece, when an insulating layer on the metal-based circuit board warps due to temperature or other reasons, the first metal piece may support the die. In addition, the second metal piece may also support the die, thereby reducing the probability of the die being crushed and damaged by the warpage. In addition, because the thickness of the metal plating layer is less than the thickness of the first metal piece and the thickness of the second metal piece , and the area is less than the area of the first metal piece and the area of the second metal piece, the effect of reducing the probability of crushing and damage is even bettered.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF DRAWINGS

Some embodiments of the present disclosure are described with reference to accompanying drawings hereinafter. Among the drawings:
FIG. 1 schematically illustrates a bottom view and a cross-sectional view of a chip package for virtual currency computation respectively according to an embodiment of the present disclosure;
FIG. 2 schematically illustrates a bottom view of a chip package for virtual currency computation according to another embodiment of the present disclosure;
FIG. 3 schematically illustrates a bottom view of a chip package for virtual currency computation according to another embodiment of the present disclosure;
FIG. 4 schematically illustrates a bottom view and a cross-sectional view of a chip package for virtual currency computation respectively according to another embodiment of the present disclosure;
FIG. 5 is a schematic diagram illustrating a chip package for virtual currency computation soldered to a metal-based circuit board according to an embodiment of the present disclosure; and
FIG. 6 is a schematic diagram illustrating a chip package for virtual currency computation soldered to a metal-based circuit board according to another embodiment of the present disclosure.

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "a plurality of," "more," or "a plurality of" refers to at least two unless otherwise specified.

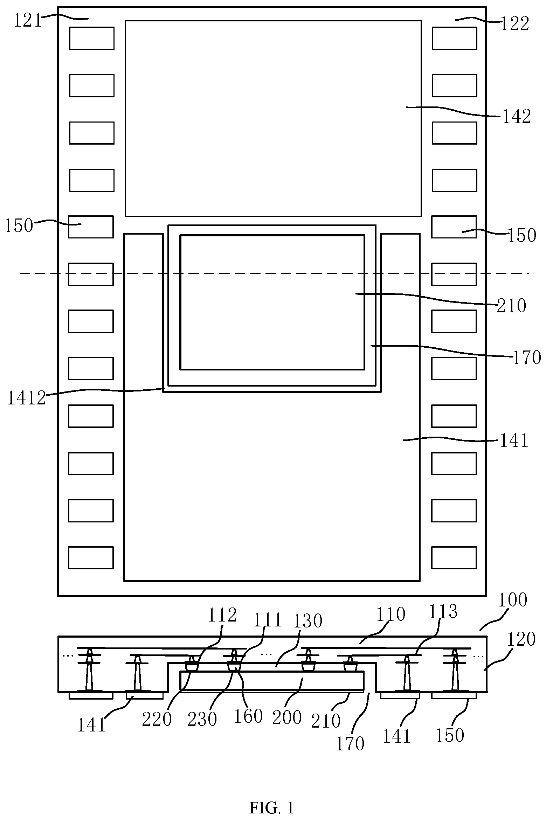

FIG. 1 schematically illustrates a bottom view and a cross-sectional view of a chip package for virtual currency computation respectively according to an embodiment of the present disclosure, in which a dashed line in the figure indicates a cross-sectional position. The chip package for virtual currency computation includes a package substrate 100 and a die 200; an outer contour of the die 200 is generally in a rectangular shape.

Die power terminals 220 and die signal terminals 230 are disposed on an upper surface of the die 200, and substrate power terminals 112 and substrate signal terminals 111 are disposed on a surface of the package substrate 100. The die power terminals 220 and the die signal terminals 230 are respectively soldered to the substrate power terminals 112 and the substrate signal terminals 111 (for example, via solder balls 160). The substrate power terminal 112s includes a substrate positive power terminal and a substrate negative power terminal; and correspondingly, the die power terminals 220 includes a die positive power terminal and a die negative power terminal.

A protruding portion 120 is arranged on the package substrate 100; the protruding portion 120 protrudes in relative to the die 200 to surround a periphery of the die 200. In other words, a recess 130 is defined in the package substrate 100 to accommodate the die 200. A plurality of chip signal terminals 150, a first metal piece 141, and a second metal piece 142 are disposed on a surface of the protruding portion 120. The substrate signal terminals 111 are electrically connected to the chip signal terminals 150 via conductive traces inside the package substrate 100. One of the first metal piece 141 and the second metal piece 142 is electrically connected to a corresponding one of the substrate positive power terminal and the substrate negative power terminal via the conductive traces 113 inside the package substrate 100; while the other one of the first metal piece 141 and the second metal piece 142 is electrically connected to the other one of the substrate positive power terminal and the substrate negative power terminal. In some embodiments, the substrate power terminals 112 includes a plurality of substrate positive power terminals and a plurality of substrate negative power terminals. One of the first metal piece 141 and the second metal piece 142 is electrically connected to all of the substrate positive power terminals, and the other of the first metal piece 141 and the second metal piece 142 is electrically connected to all of the substrate negative power terminals. In this way, the die 200 may be allowed to operate at a greater current.

A metal plating layer 210 is disposed on a lower surface of the die 200 to facilitate the soldering of the die 200 to a metal-based circuit board 300. In addition, for better heat dissipation of the die 200, the metal plating layer 210 is very thin. A thickness of the metal plating layer 210 is less than a thickness of the first metal piece 141 and the thickness of the second metal piece 142, and an area of the metal plating layer 210 is less than an area of the first metal piece 141 and the area of the second metal piece 142. The metal plating layer 210 may be a nickel-palladium-gold, copper, or nickel plating layer, and may be manufactured through any of various existing processes for forming a thin metal layer, such as evaporation, sputtering, or the like.

A projection of the metal plating layer 210 on the surface where the first metal piece 141 is disposed is located within the first metal piece 141, and the die 200 is electrically isolated from both the first metal piece 141 and the second metal piece 142. In one embodiment, a surface of the metal plating layer 210 is on a same horizontal plane as a surface of the first metal piece 141 and a surface of the second metal piece 142. In another embodiment, the surface of the metal plating layer 210 is slightly lower than the surface of the first metal piece 141 and the surface of the second metal piece 142. In other words, viewed from a bottom of the chip package for virtual currency computation, the surface of the metal plating layer 210 is slightly recessed inward. In yet another embodiment, the surface of the metal plating layer 210 is slightly higher than the surface of the first metal piece 141 and the surface of the second metal piece 142. In other words, viewed from the bottom of the chip package for virtual currency computation, the surface of the metal plating layer 210 slightly protrudes outward.

The metal plating layer 210, the first metal piece 141, the second metal piece 142, and the chip signal terminals 150 are configured to be soldered to a surface on one side of the metal-based circuit board 300, for example, all soldered to an upper surface of the metal-based circuit board 300.

In the above solution, upon being soldered to the metal-based circuit board 300, the die 200 in the chip package for virtual currency computation is soldered to a corresponding heat dissipation pad or a thermal separation boss on the metal-based circuit board 300 via the very thin metal plating layer 210, and a large amount of heat generated by the die 200 due to virtual currency computation may be easily transferred to the metal-based circuit board 300 and subsequently dissipated by the metal base, such that the heat dissipation efficiency is improved. The trade-off is that the lower surface of the die 200 has almost no package protection. However, since the projection of the metal plating layer 210 on the surface where the first metal piece 141 is disposed is located within the first metal piece 141, when an insulating layer on the metal-based circuit board 300 warps due to temperature or other reasons, the first metal piece 141 may support the die 200. In addition, the second metal piece 142 may also support the die 200, thereby reducing the probability of the die 200 being crushed and damaged by the warpage. In addition, because the thickness of the metal plating layer 210 is less than the thickness of the first metal piece 141 and the thickness of the second metal piece 142, and the area is less than the area of the first metal piece 141 and the area of the second metal piece 142, the effect of reducing the probability of crushing and damage is even better.

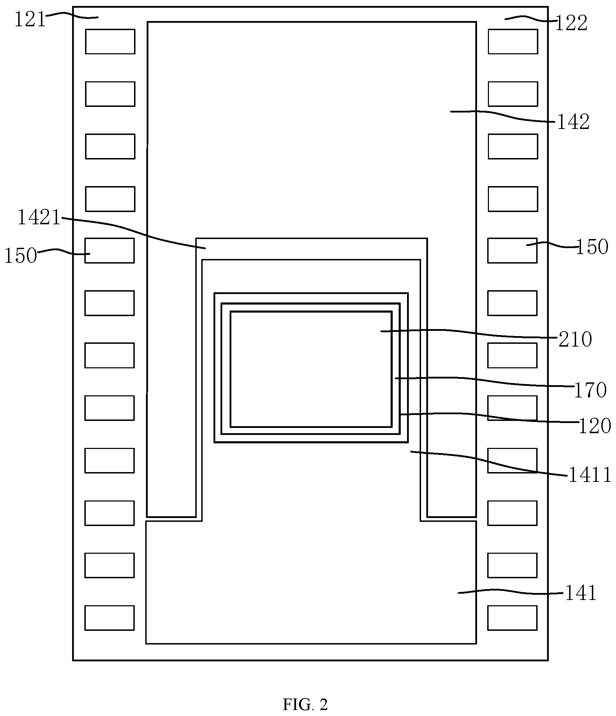

In some embodiments, as illustrated in FIG. 2, the first metal piece 141 is provided with a metal projection part 1411, and the second metal piece 142 is provided with a metal recess part 1421; the metal projection part 1411 extends into the metal recess part 1421. The projection of the metal plating layer 210 on the surface where the first metal piece 141 is disposed completely is located within the metal projection part 1411 and is thereby surrounded by the metal projection part 1411. In this embodiment, the metal projection part 1411 extends into the metal recess 1421, and thus the metal projection part 1411 and the metal recess part 1421 are interleaved with each other. Therefore, the first metal piece 141 and the second metal piece 142 may interact with each other and jointly support the metal plating layer 210. Furthermore, because the projection of the metal plating layer 210 on the surface where the first metal piece 141 is disposed completely is located within the metal projection part 1411, the metal plating layer 210 is disposed at a middle interleaved position between the first metal piece 141 and the second metal piece 142. The middle interleaved position is a relatively optimal position for achieving a better support effect.

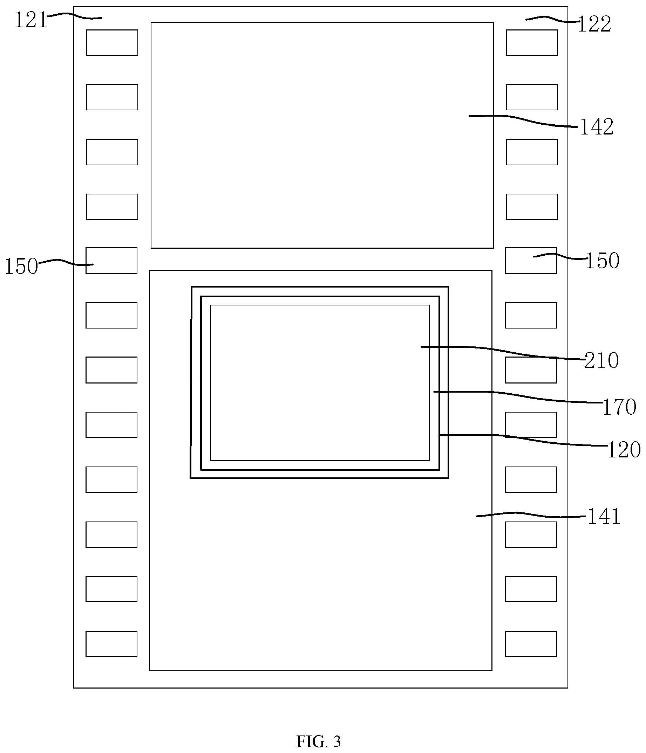

In some embodiments, as illustrated in FIG. 3, the first metal piece 141 and the second metal piece 142 are arranged in a side-by-side manner, and each of the first metal piece 141 and the second metal piece 142 has a rectangular outer contour. The projection of the metal plating layer 210 on the surface where the first metal piece 141 is disposed completely is located within the first metal piece 141, and is thus surrounded by the first metal piece 141. In this embodiment, similarly, the metal plating layer 210 may be supported by both the first metal piece 141 and the second metal piece 142.

In some embodiments, as illustrated in FIG. 1, the first metal piece 141 has a notch part 1412, the second metal piece 142 is in a rectangular shape, and the first metal piece 141 and the second metal piece 142 are arranged in a side-by-side manner. The projection of the metal plating layer 210 on the surface where the first metal piece 141 is disposed is located within the notch part 1412 of the first metal piece 141. In this embodiment, similarly, the metal plating layer 210 may be supported by both the first metal piece 141 and the second metal piece 142. In some more specific embodiments, three sides of the projection of the metal plating layer 210 on the surface where the first metal piece 141 is disposed respectively face three corresponding sides of the notch part 1412, and a fourth side of the projection of the metal plating layer 210 faces a fourth side of the second metal piece 142.

In some embodiments, the chip signal terminals 150 are disposed on a first side region 121 and an opposite second side region 122 of the package substrate 100 that are opposite to each other; the first metal piece 141 and the second metal piece 142 are disposed between the chip signal terminals 150 on the first side region 121 and the chip signal terminals 150 on the second side region 122. In this way, the first metal piece 141 and the second metal piece 142 may be closer to the metal plating layer 210, thereby providing support for the metal plating layer 210.

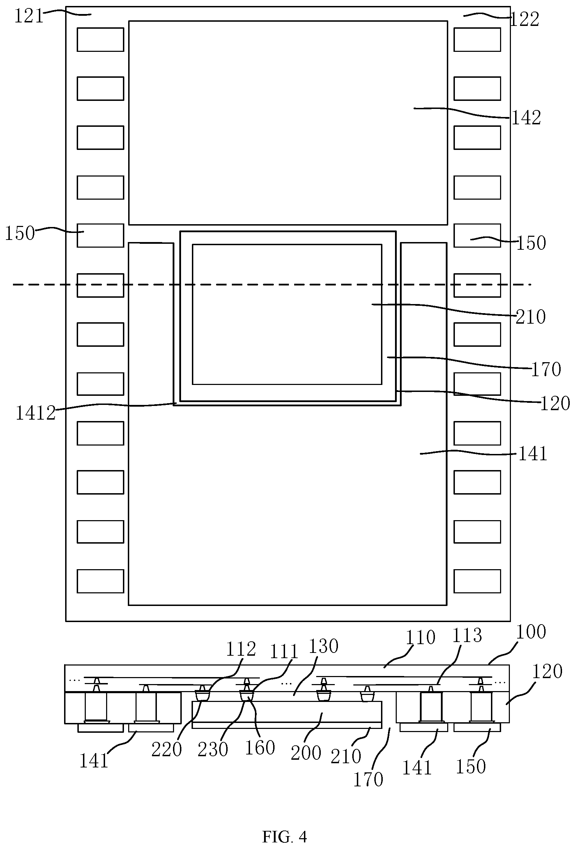

As described above, the package substrate 100 includes a base substrate 110 and the protruding portion 120. In some embodiments, as illustrated in FIG. 1, the base substrate 110 and the protruding portion 120 are integrated into a one-piece configuration. During manufacturing of the one-piece configuration, an accommodating groove 130 for accommodating the die 200 is provided in a middle portion. For example, a length and a width of the accommodating groove 130 are respectively 0.1 mm to 2 mm greater than the length and the width of the die 200, and a depth of the accommodating groove 130 is 0.05 mm to 3 mm. In case that the die 200 is fixed in the accommodating groove 130 by soldering via the solder balls 160 (the substrate power terminals 112 and the substrate signal terminals 111 are arranged at a bottom of the accommodating groove 130 and are respectively soldered to the die power terminals 220 and the die signal terminals 230), the lower surface of the die 200 and a lower surface of the protruding portion 120 are on a same plane or substantially on a same plane. Thereafter, a gap 170 among the die 200, the base substrate 110 and the protruding portion 120 is filled and reinforced by plastic molding; and the die 200 is surrounded by the protruding portion 120 surrounds the die 200. Furthermore, the chip signal terminals 150, the first metal piece 141, and the second metal piece 142 are manufactured on the lower surface of the protruding portion 120 to serve as external pins for the chip package for virtual currency computation. In some other embodiments, as illustrated in FIG. 4, the protruding portion 120 is formed on the base substrate 110 by plastic molding. Specifically, the die 200 may firstly be soldered to the substrate power terminals 112 and the substrate signal terminals 111 on the base substrate 110 via the solder balls 160; then a plurality of copper pillars are formed on internal power terminals and internal signal terminals of the base substrate 110 in a peripheral of the die 200 by a copper pillar manufacturing process; and thereafter, the protruding portion 120 is formed by plastic molding such that the copper pillars are positioned inside the protruding portion 120; furthermore, the chip signal terminals 150, the first metal piece 141, and the second metal piece 142 are manufactured on the lower surface of the protruding portion 120 to serve as external pins for the chip package for virtual currency computation. In this case, the copper pillars are configured as a circuit part of the chip signal terminal 150, the first metal piece 141, and the second metal piece 142 inside the package substrate 100. For example, the chip signal terminals 150 is electrically connected to the substrate signal terminals 111 via the corresponding copper pillars and the conductive traces 113 inside the base substrate 110.

In some embodiments, the package substrate 100 includes multiple layers of conductive traces 113 arranged therein to meet requirements of multi-pins and small-area for the chip package for virtual currency computation .

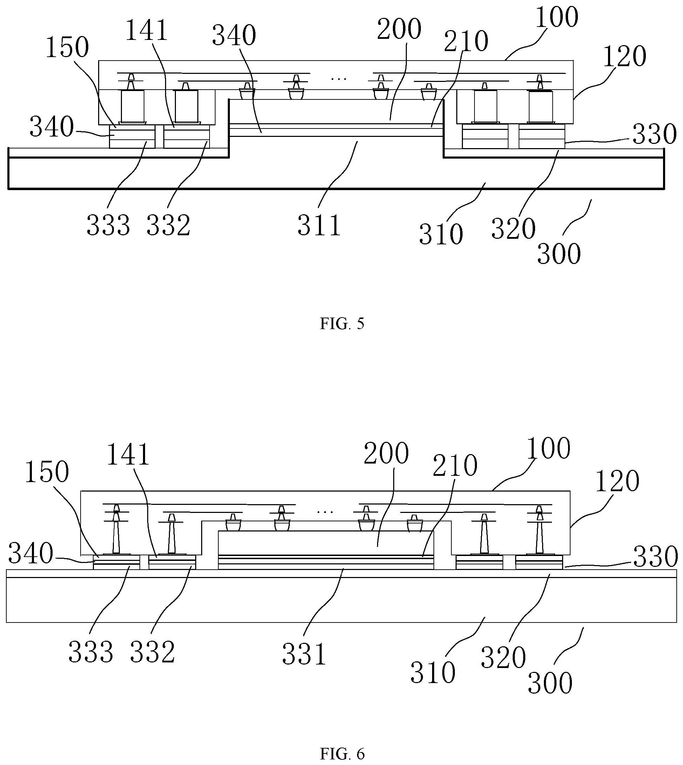

FIG. 5 illustrates a circuit device for virtual currency computation according to an embodiment of the present disclosure. As illustrated in FIG. 5, the circuit device includes a metal-based circuit board 300 and the chip package for virtual currency computation. The metal-based circuit board 300 includes a metal substrate 310; a thermal separation boss 311 is disposed on the metal substrate 310, and an insulating layer 320 is disposed on a surface of the metal substrate 310 other than the thermal separation boss 311. A conductive layer 330 is disposed on the insulating layer 320; the conductive layer 330 includes a first power pad 332, a second power pad (not marked in the figure), and a plurality of signal pads 333. The metal plating layer 210 is soldered to the thermal separation boss 311; and the first metal piece 141, the second metal piece 142, and the chip signal terminals 150 are respectively soldered to the first power pad 332, the second power pad, and the signal pads 333 via solder 340. In this embodiment, the thermal separation boss 311 serves as the metal substrate 310 that is directly in soldering contact with the metal plating layer 210 on the die 200, heat on the die 200 may be efficiently conducted to the metal substrate 310. Therefore, the heat dissipation efficiency is much greater than the heat dissipation efficiency that might otherwise be achieved by contacting the die 200 with the metal substrate 310 by a thermal conductive adhesive.

FIG. 6 illustrates a circuit device for virtual currency computation according to another embodiment. As illustrated in FIG. 6, the circuit device includes a metal-based circuit board 300 and the chip package for virtual currency computation. The metal-based circuit board 300 includes a metal substrate 310, and an insulating layer 320 is disposed on a surface of the metal substrate 310. A conductive layer 330 is disposed on the insulating layer 320; the conductive layer 330 includes a heat dissipation pad, a first power pad 332, a second power pad, and a plurality of signal pads 333. The metal plating layer 210, the first metal piece 141, the second metal piece 142, and the chip signal terminals 150 are respectively soldered to the heat dissipation pad, the first power pad 332, the second power pad, and the signal pads 333 via solder 340. In this embodiment, the die 200 is soldered via the heat dissipation pad, and heat is transferred to the metal substrate 310 via the heat dissipation pad to be dissipated, which may also achieve high heat dissipation efficiency.

In some embodiments, a glass transition temperature (Tg) of the metal-based circuit board 300 is greater than or equal to 170°C. When the temperature of the metal-based circuit board 300 changes, the degree of bending or warpage of the insulating layer 320 on the metal substrate 310 is relatively small, and thus the probability of the die 200 being crushed and damaged resulting therefrom is reduced. Apparently, the metal-based circuit board 300 according to this embodiment may reduce the probability of the die 200 being crushed and damaged due to bending.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A chip package for virtual currency computation, comprising:
a package substrate comprising substrate power terminals and substrate signal terminals arranged on a surface thereof, the substrate power terminal comprising a substrate positive power terminal and a substrate negative power terminal; and
a die comprising die power terminals and die signal terminals arranged on an upper surface thereof, the die power terminals and the die signal terminals being soldered to the substrate power terminals and the substrate signal terminals respectively;
wherein a protruding portion surrounding a periphery of the die and protruding in relative to the die is arranged on the package substrate, the protruding portion comprises a plurality of chip signal terminals, a first metal piece, and a second metal piece arranged on a surface thereof;
the substrate signal terminals are electrically connected to the chip signal terminals via conductive traces inside the package substrate; each of the first metal piece and the second metal piece are electrically connected to the substrate positive power terminal and the substrate negative power terminal respectively via a respective conductive trace inside the package substrate;
a metal plating layer is disposed on a lower surface of the die, wherein a thickness of the metal plating layer is less than a thickness of the first metal piece and a thickness of the second metal piece, and an area of the metal plating layer is less than an area of the first metal piece and an area of the second metal piece;
a projection of the metal plating layer on a surface where the first metal piece is disposed is located within the first metal piece, and the die is electrically isolated from both the first metal piece and the second metal piece; and
the metal plating layer, the first metal piece, the second metal piece, and the chip signal terminals are configured to be soldered to a surface on one side of a metal-based circuit board.

2. The chip package for virtual currency computation according to claim 1, wherein
the first metal piece has a metal projection part, and the second metal piece has a metal recess part, the metal projection part extends into the metal recess part; and
the projection of the metal plating layer on the surface where the first metal piece is disposed completely is located within the metal projection part and is surrounded by the metal projection part.

3. The chip package for virtual currency computation according to claim 1, wherein
the first metal piece and the second metal piece are arranged in a side-by-side manner, and each of the first metal piece and the second metal piece has a rectangular outer contour; and
the projection of the metal plating layer on the surface where the first metal piece is disposed completely is located within the first metal piece and is surrounded by the first metal piece.

4. The chip package for virtual currency computation according to claim 1, wherein
the first metal piece has a notch part, the second metal piece is in a rectangular shape, and the first metal piece and the second metal piece are arranged in a side-by-side manner; and
the projection of the metal plating layer on the surface where the first metal piece is disposed is located within the notch part of the first metal piece.

5. The chip package for virtual currency computation according to claim 4, wherein
three sides of the projection of the metal plating layer on the surface where the first metal piece is disposed respectively face three sides of the notch part, and a fourth side of the projection faces a fourth side of the second metal piece.

6. The chip package for virtual currency computation according to any one of claims 1 to 5, wherein the chip signal terminals are arranged on a first side region and an opposite second side region of the package substrate, and the first metal piece and the second metal piece are disposed between the chip signal terminals on the first side regions and the chip signal terminals on the second side region.

7. The chip package for virtual currency computation according to any one of claims 1 to 5, wherein multiple layers of conductive traces are disposed inside the package substrate.

8. The chip package for virtual currency computation according to any one of claims 1 to 5, wherein the package substrate comprises a base substrate, and the protruding portion is formed by plastic molding; wherein a plurality of copper pillars are disposed inside the protruding portion, the copper pillars are configured as a circuit part of the chip signal terminals, the first metal piece, and the second metal piece inside the package substrate.

9. The chip package for virtual currency computation according to claim 1, wherein the metal plating layer is a nickel-palladium-gold, copper, or nickel plating layer.

10. A circuit device for virtual currency computation, comprising: a metal-based circuit board and the chip package for virtual currency computation as defined in any one of claims 1 to 9; wherein
the metal-based circuit board comprises a metal substrate, wherein a thermal separation boss is disposed on the metal substrate, and an insulating layer is disposed on a surface of the metal substrate other than the thermal separation boss, a conductive layer being disposed on the insulating layer, the conductive layer comprising a first power pad, a second power pad, and a plurality of signal pads; and
the metal plating layer is soldered to the thermal separation boss;
wherein the first metal piece, the second metal piece, and the chip signal terminals are respectively soldered to the first power pad, the second power pad, and the signal pads.

11. A circuit device for virtual currency computation, comprising: a metal-based circuit board and the chip package for virtual currency computation as defined in any one of claims 1 to 9; wherein the metal-based circuit board comprises a metal substrate, wherein an insulating layer is disposed on a surface of the metal substrate, a conductive layer being disposed on the insulating layer, the conductive layer comprising a heat dissipation pad, a first power pad, a second power pad, and a plurality of signal pads;
wherein the metal plating layer, the first metal piece, the second metal piece, and the chip signal terminals are respectively soldered to the heat dissipation pad, the first power pad, the second power pad, and the signal pads.

12. The circuit device for virtual currency computation according to claim 10 or 11, wherein a glass transition temperature of the metal-based circuit board is greater than or equal to 170°C such that a probability of the metal-based circuit board crushing and damaging the die due to bending is reduced.
